Europäisches Patentamt

European Patent Office

Office européen des brevets

(19)

(11) Numéro de publication: **0 033 677**
**B1**

(12)

# FASCICULE DE BREVET EUROPEEN

(45) Date de publication du fascicule du brevet: **18.05.83**

(51) Int. Cl.³: **H 05 K 3/36**

(21) Numéro de dépôt: **81400053.5**

(22) Date de dépôt: **16.01.81**

(54) Assemblage de cartes de circuits imprimés et son procédé de fabrication.

(30) Priorité: **29.01.80 FR 8001891**

(43) Date de publication de la demande:
**12.08.81 Bulletin 81/32**

(45) Mention de la délivrance du brevet:
**18.05.83 Bulletin 83/20**

(84) Etats contractants désignés:
**BE DE FR GB IT NL SE**

(56) Documents cités:
**FR - A - 1 239 226**
**FR - A - 1 481 461**
**US - A - 3 780 431**

(73) Titulaire: **THOMSON-BRANDT**
**173, Boulevard Haussmann**
**F-75379 Paris Cedex 08 (FR)**

(72) Inventeur: **Dongois, Gérard**
**THOMSON-CSF SCPI 173, Bld Haussmann**
**F-75360 Paris Cedex 08 (FR)**
Inventeur: **Pataillot, Georges**
**THOMSON-CSF SCPI 173, Bld Haussmann**
**F-75360 Paris Cedex 08 (FR)**
Inventeur: **Hascoet, Max**
**THOMSON-CSF SCPI 173, Bld Haussmann**
**F-75360 Paris Cedex 08 (FR)**
Inventeur: **Canon, Louis**
**THOMSON-CSF SCPI 173, Bld Haussmann**
**F-75360 Paris Cedex 08 (FR)**

(74) Mandataire: **Grynwald, Albert et al,**
**THOMSON-CSF SCPI 173, Bld Haussmann**
**F-75379 Paris Cedex 08 (FR)**

Courier Press, Leamington Spa, England.

Assemblage de cartes de circuits imprimes et son procede de fabrication

L'invention est relative à un assemblage d'au moins deux cartes de circuits imprimés ainsi qu'à un procédé de fabrication d'un tel assemblage.

On sait qu'une carte de circuits imprimés est une plaquette isolante à laquelle sont fixés des composants électriques ou électroniques et sur laquelle sont dessinées, sur au moins une de ses faces, des pistes de cuivre formant des connexions entre composants. De telles cartes sont utilisées pratiquement dans tous les appareils faisant appel à des composants électroniques. Un certain nombre de ces appareils font même appel à plusieurs cartes de circuits imprimés assemblées les unes aux autres par des moyens assurant une liaison à la fois électrique et mécanique.

On a déjà proposé (brevet français 1 239 226) un tel assemblage de cartes de circuits imprimés dans lequel, pour assurer la liaison mécanique et électrique, des étriers ou agrafes chevauchent les bords adjacents des cartes assemblées et présentent deux bras pénétrant dans des trous formés dans chaque carte. Dans cet assemblage connu les étriers sont apparents et risquent, si les fils ne sont pas isolés et si des précautions particulières ne sont pas prises, de se détériorer et/ou de provoquer une altération du fonctionnement des circuits de l'appareil dont ils font partie, par exemple par court-circuit entre des étriers voisins. Ces inconvénients sont encore plus graves lorsque les cartes ne sont pas dans un même plan, car les étriers sont alors en saillie du coin formé par les deux cartes assemblées.

L'invention remédie à ces inconvénients.

Selon l'invention un assemblage d'au moins deux cartes de circuits imprimés connectées l'une à l'autre par une liaison à la fois mécanique et électrique comportant des étriers ou agrafes chevauchant des bords adjacents des cartes est caractérisé en ce que la partie centrale de chaque agrafe est disposée au moins partiellement dans une encoche formée dans les cartes au voisinage des bords adjacents.

De cette manière chaque agrafe est protégée et peut être constituée par un fil conducteur nu, c'est-à-dire non gainé. Le coût d'un tel assemblage est donc réduit.

Dans le mode de réalisation préféré de l'invention les encoches sont allongées perpendiculairement aux bords adjacents. Un tel assemblage est de fabrication aisée notamment lorsqu'on part d'un même plaquette pour fabriquer les deux cartes. Dans ce cas les encoches proviennent de trous oblongs ou fentes d'axes parallèles percés dans la plaquette de départ, la ligne de séparation étant alors la médiatrice de ces trous oblongs. Les agrafes peuvent, dans ce cas, avoir la forme d'un simple U avec une branche centrale rectiligne; on a en effet constaté qu'ainsi, après pliage de la plaquette pour former les deux cartes, une telle agrafe ne subit pas de contrainte mécanique de traction.

Il est particulièrement avantageux que les dimensions des agrafes soient voisines de celles des composants, telles que des résistances, de manière à pouvoir être installées automatiquement par les mêmes outils ou machines qui permettent la mise en place automatique des composants sur une plaquette de circuits imprimés.

D'autres caractéristiques et avantages de l'invention apparaîtront avec la description de certains de ses modes de réalisation, celle-ci étant effectuée en se référant aux dessins ci-annexés sur lesquels:

—la figure 1 est une vue en perspective d'une plaque de circuit imprimé avant sa séparation en deux cartes assemblées selon l'invention,

—la figure 2 est une vue analogue à celle de la figure 1 mais pour une étape ultérieure de fabrication de l'assemblage de cartes,

—la figure 3 est une coupe selon la ligne III—III de la figure 2,

—la figure 4 est une vue de la plaque de la figure 1 disposée dans un châssis,

—la figure 5 représente un plaque destinée à former trois cartes de circuits imprimés, et

—la figure 6 est une vue en perspective montrant trois cartes de circuits imprimés réalisées à partir de la plaque de la figure 5.

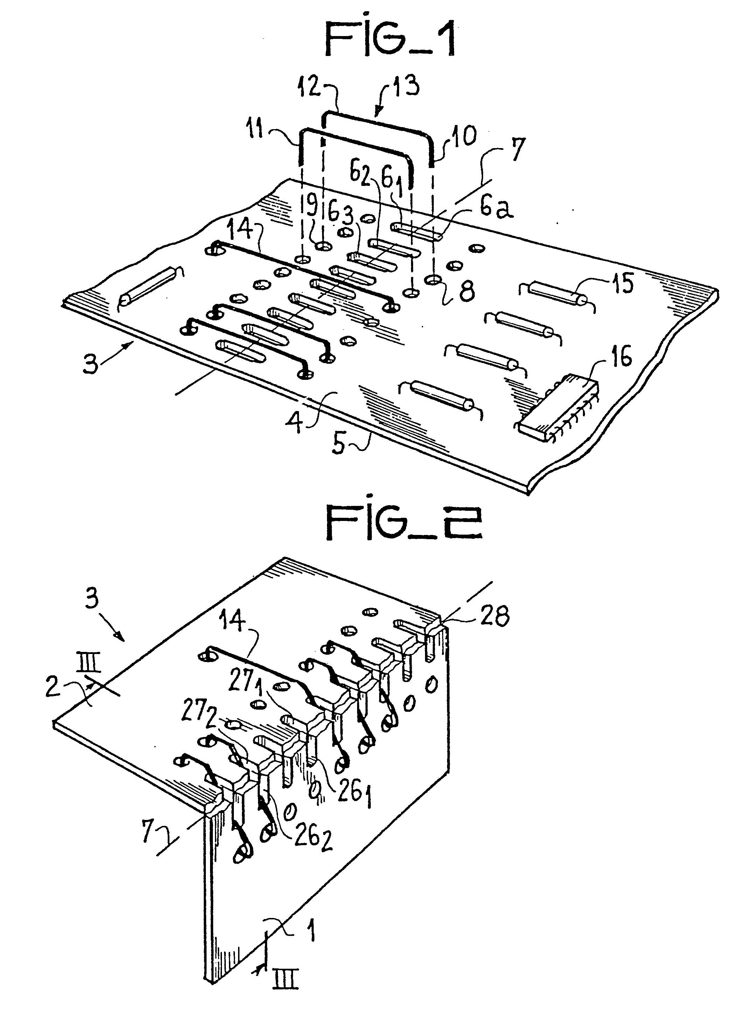

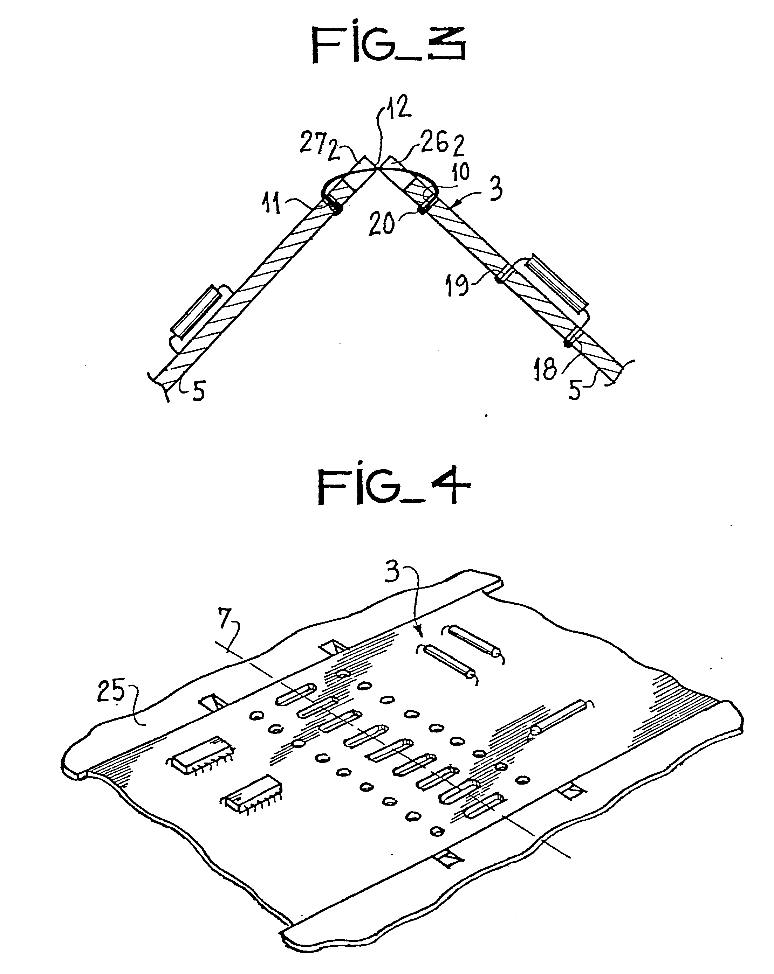

On se réfère tout d'abord aux figures 1 à 4.

Pour fabriquer un assemblage de deux cartes de circuits imprimés on part d'une plaque unique 3 de circuits imprimés qui, de façon en soi connue, est constituée par une plaque isolante 4 dont une face 5 est recouverte par une pellicule conductrice de l'électricité, du cuivre de façon générale.

Selon l'invention la plaque 3 est percée de trous oblongs ou fentes $6_1$, $6_2$ etc ... identiques entre eux et disposés à intervalles réguliers les uns des autres avec leurs grands axes $6_a$ parallèles et de façon telle que la médiatrice de ces grands axes forme une seule ligne 7. Au cours d'une étape ultérieure de la fabrication la plaque 3 est brisée selon cette ligne 7 pour former les deux cartes 1 et 2.

A chaque trou oblong, par exemple celui de référence $6_3$, sont associés de petits trous circulaires 8 et 9 disposés de part et d'autre de la ligne 7 et dont les centres se trouvent sur la ligne prolongeant le grand axe du trou oblong $6_3$ correspondant.

Ces trous traversants 8 et 9 sont destinés à recevoir les extrémités des branches libres 10 et 11 d'une agrafe 13 constituée par un fil de cuivre rigide ayant la forme d'un simple U à base rectiligne allongée 12 et deux branches 10 et 11, également rectilignes, perpendiculaires à la base 12.

Les agrafes 13 chevauchent ainsi la ligne 7 qui constitue en général leur axe de symétrie. Cette symétrie n'est cependant pas indispensable; ainsi l'agrafe 14 n'est pas disposée symétriquement par rapport à la ligne 7.

Sur la plaque 3, après perçage d'un ensemble de petits trous circulaires de faible diamètre identiques aux trous 8 et 8, les composants électroniques, tels que des résistances 15 et des circuits intégrés 16, sont mis en place de façon automatique à l'aide d'une machine connue en elle-même. Les agrafes 13, 14 ont des dimensions et une forme la machine peut être également utilisée pour la mise en place de ces agrafes.

Le dessin des pistes conductrices, pour la connexion entre les composants, est formé de façon classique par élimination d'une partie de la pellicule de cuivre 5, avant la formation des trous oblongs et des trous circulaires.

La plupart des trous circulaires sont à l'extrémité d'une piste conductrice correspondante. Cependant certains trous 8, 9 ne sont pas associés à une piste conductrice car les agrafes dont ils reçoivent les branches ont uniquement un rôle de connexion mécanique; cette disposition est utile, pour renforcer la liaison mécanique, notamment lorsque le nombre de liaisons électriques nécessaires entre deux cartes est relativement faible.

Après mise en place des composants 15, 16 et des agrafes 13, 14 c'est-á-dire introduction de leurs branches d'extrémité 10, 11 dans les trous circulaires correspondants on effectue les soudures desdites branches aux pistes conductrices correspondantes par exemple par une opération de soudure à la vague. Les extrémités des branches 10 et 11 des agrafes et des branches 18 et 19 des composants (figure 3) sont ainsi solidaires de pastilles de soudure 20 elles mêmes soudées à la pellicule 5 de la plaque 3. Ces pastilles 20 assurent la connexion à la fois électrique et mécanique des agrafes et des composants à la plaque de circuits imprimés.

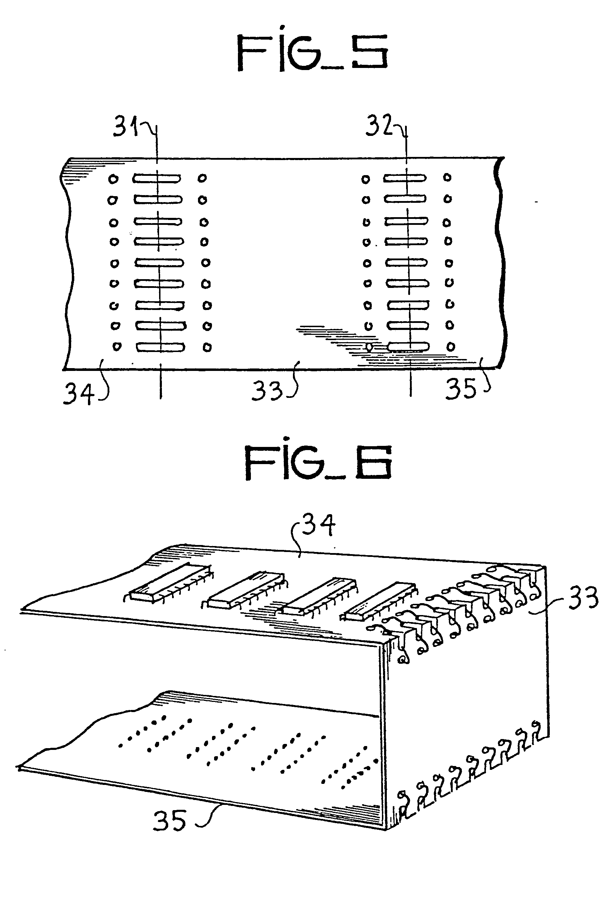

La plaque 3 ainsi formée est disposée dans un châssis ou cadre métallique 25 (figure 4) qui est plié selon la ligne 7. Les cartes 1 et 2 sont alors séparées l'une de l'autre, la plaque 3 se brisant selon ladite ligne 7 qui constitue, en raison des trous oblongs 6, une ligne de moindre résistance mécanique. En variante la division de la plaque 3 est effectuée sans faire intervenir de châssis ou cadre.

Après cette séparation la partie de chaque trou oblong qui reste sur une carte forme une encoche 26 ou 27 dans laquelle vient se loger la partie centrale de la branche 12 de l'agrafe correspondante. Ces encoches constituent ainsi des logements pour la partie centrale des agrafes, ce qui évite que celles-ci soient en saillie du coin 28 formé par les deux cartes 1 et 2 assemblées et diminue le risque de contact entre deux agrafes adjacentes. C'est la raison pour laquelle le fil conducteur constituant ces agrafes peut rester nu.

La longeur du grand axe de chaque trou oblong 6, la disposition des trous 8 et 9 et les longueurs des branches 10 et 11 des agrafes devront être telles qu'aucune traction ne soit exercée sur ces fils rigides lors du pliage et que ces fils soient tous dans le même plan après le pliage. L'absence de traction permet de ne pas altérer les propriétés mécanique des fils et en particulier de conserver leur rigidité. En outre le choix des paramètres mentionnés ci-dessus doit être tel que la branche centrale 12 n'entre pas en contact avec le fond des encoches $26_2$ et $27_2$ (figure 3).

Il sera préférable, pour faciliter la fabrication, que toutes les agrafes aient des dimensions identiques, que tous les trous 8 soient sur une même ligne et que, de même, tous les trous 9 soient alignés.

On se réfère maintenant aux figures 5 et 6.

On a représenté de façon schématique sur la figure 5 une plaque 30 de circuits imprimés dans laquelle ont été formées deux séries de trous oblongs selon des lignes parallèles 31 et 32, la plaque 30 étant ainsi destinée à former trois cartes de circuits imprimés respectivement 33, 34 et 35, les cartes 34 et 35 étant disposées parallèlement l'une à l'autre et perpendiculairement à la carte 33 (figure 6).

Il n'est pas indispensable que les plans des cartes forment entre eux un angle de 90°, celui-ci peut être plus grand ou plus petit.

Dans l'exemple des figures 5 et 6 les cartes sont, comme dans l'exemple des figures 1 à 4, solidaires d'un même châssis (non représenté).

L'invention se prête à de nombreuses applications. Elle peut être utilisée à chaque fois que des cartes de circuits imprimés doivent être assemblées de façon mécanique et électrique, notamment dans des plan distincts, par exemple dans des téléviseurs.

**Revendications**

1. Assemblage d'au moins deux cartes de circuits imprimés connectées l'une à l'autre par une liaison à la fois mécanique et électrique comportant des agrafes chevauchant des bords adjacents des cartes, caractérisé en ce que la partie centrale (12) de chaque agrafe (13) est disposée au moins partiellement dans des encoches (26, 27) formées dans les cartes (1, 2) au voisinage des bords adjacents.

2. Assemblage selon la revendication 1, caractérisé en ce que les encoches (26, 27) sont allongées perpendiculairement aux bords adjacents.

3. Assemblage selon la revendication 1 ou 2, caractérisé en ce que les extrémités de chaque agrafe sont introduites dans des trous (8, 9) formés dans chaque carte de part et d'autre des encoches correspondantes.

4. Assemblage selon la revendication 3, caractérisé en ce que les trous (8, 9) bordant certaines encoches sont à l'extrémité, du côté conducteur de chaque carte, d'une piste conductrice de liaison.

5. Assemblage selon l'une quelconque des revendications précédentes, caractérisé en ce que chaque agrafe à la forme d'un simple U avec une base (12) et des branches (10, 11) rectilignes.

6. Assemblage selon l'une quelconque des revendications précédentes, caractérisé en ce que chaque agrafe est constituée par un fil conducteur rigide.

7. Assemblage selon l'une quelconque des revendications précédentes, caractérisé en ce que chaque agrafe est constituée par un fil conducteur nu.

8. Assemblage selon l'une quelconque des revendications précédentes, caractérisé en ce que certaines des agrafes ont un rôle de connexion mécanique sans fonction de liaison électrique.

9. Assemblage selon l'une quelconque des revendications précédentes, caractérisé en ce que les agrafes ont des formes et dimensions autorisant leur installation automatique, par les outils ou machines utilisés pour la mise en place des composants sur une plaquette.

10. Assemblage selon l'une quelconque des revendications précédentes, caractérisé en ce que chaque encoche ne loge qu'une seule agrafe.

11. Assemblage selon l'une quelconque des revendications précédentes, caractérisé en ce que les cartes sont dans des plans distincts.

12. Procédé de fabrication d'un assemblage de cartes de circuits imprimés selon l'une quelconque des revendications précédente, caractérisé en ce qu'on part d'une plaque unique (3) de circuits imprimés, munie de trous oblongs (6) définissant une ligne (7) de moindre résistance mécanique de part et d'autre de laquelle sont menagés des trous (8, 9) destinés à recevoir les agrafes (13), on forme les circuits de chaque carte (1, 2; 33, 34, 35) sur cette plaque, on installe les agrafes (13) dans les trous (8, 9) et on sépare les deux cartes par pliage autour de ladite ligne (7) de moindre résistance mécanique, les encoches (26, 27) étant obtenues par l'ouverture desdits trous oblongs consécutive à la rupture de ladite plaque unique.

13. Procédé selon la revendication, 12, pour la fabrication d'un assemblage selon la revendication 2, caractérisé en ce qu'on forme les trous oblongs (6) tels que la ligne de moindre résistance mécanique soit la médiatrice des grands axes de ces trous.

14. Procédé selon la revendication 12 ou 13, caractérisé en ce que la mise en place des agrafes est effectuée à l'aide des mêmes outils que ceux permettant la mise en place des autres composants (15, 16) des cartes.

**Patentansprüche**

1. Anordnung von mindestens zwei Leiterplatten, die miteinander durch eine gleichzeitig mechanische und elektrische Verbindung verbunden sind, die Klammern aufweist, welche benachbarte Kanten der Leiterplatten übergreift, dadurch gekennzeichnet, daß der Mittelteil (12) jeder Klammer (13) mindestens teilweise in Kerben (26, 27) angeordnet ist, die in den Leiterplatten (1, 2) in der Nähe der benachbarten Kanten ausgebildet sind.

2. Anordnung nach Anspruch 1, dadurch gekennzeichnet, daß die Kerben (26, 27) senkrecht zu den benachbarten Kanten langgestreckt sind.

3. Anordnung nach Anspruch 1 oder 2, dadurch gekennzeichnet, daß die Enden jeder Klammer in Löcher (8, 9) eingeführt sind, die in jeder Leiterplatte auf der einen und anderen Seite der entsprechenden Kerben ausgebildet sind.

4. Anordnung nach Anspruch 3, dadurch gekenzeichnet, daß die Löcher (8, 9) welche bestimmte Kerben einfassen, auf der Leiterseite jeder Leiterplatte am Ende einer Verbindungsleiterbahn sind.

5. Anordnung nach einem der vorangehenden Ansprüche, dadurch gekennzeichnet, daß jede Klammer die Form eines einfachen U mit einer Basis (12) und geraden Schenkeln (10, 11) hat.

6. Anordnung nach einem der vorangehenden Ansprüche, dadurch gekennzeichnet, daß jede Klammer aus einem starren Leitungsdraht besteht.

7. Anordnung nach einem der vorangehenden Ansprüche, dadurch gekennzeichnet, daß jede Klammer aus einem nackten Leitungsdraht besteht.

8. Anordnung nach einem der vorangehenden Ansprüche, dadurch gekennzeichnet, daß bestimmte der Klammern als mechanische Verbindung ohne die Funktion einer elektrischen Verbindung dienen.

9. Anordnung nach einem der vorangehenden Ansprüche, dadurch gekennzeichnet, daß die Klammern solche Formen und Abmessungen haben, daß ihre automatische Montage durch Werkzeuge oder Maschinen möglich ist, die zur Montage von Bauteilen auf einer Leiterplatte verwendet werden.

10. Anordnung nach einem der vorangehenden Ansprüche, dadurch gekennzeichnet, daß jede Kerbe nur eine einzige Klammer aufnimmt.

11. Anordnung nach einem der vorangehende Ansprüche, dadurch gekennzeichnet, daß die Leiterplatten sich in verschiedenen Ebenen befinden.

12. Verfahren zur Herstellung einer Anordnung von Leiterplatten nach einem der vorangehenden Ansprüche, dadurch gekennzeichnet, daß man von einer einzigen Leiterplatte (3) ausgeht, die mit Langlöchern (6) versehen ist, welche eine Linie (7) des geringsten mechanischen Widerstands definieren, beiderseits welcher die zur Aufnahme der Klammern (13) bestimmten Löcher (8, 9) ausgebildet sind, daß man die Stromkreise jeder Leiterplatte (1, 2; 33, 34, 35) auf dieser Platte bildet, daß man die Klammern (13) in den Löchern (8, 9) montiert und die beiden Leiterplatten durch Biegen um die Linie (7) des geringsten mechanischen Widerstands trennt, wobei die Kerben (26, 27) durch die Öffnung der Langlöcher infolge des Bruchs der einzigen Platte erhalten werden.

13. Verfahren nach Anspruch 12 zur Herstellung einer Anordnung nach Anspruch 2, dadurch gekennzeichnet, daß man die Langlöcher (6) so ausbildet, daß die Linie des geringsten mechanischen Widerstands die Mittelsenkrechte der großen Achsen dieser Löcher ist.

14. Verfahren nach Anspruch 12 oder 13, dadurch gekennzeichnet, daß die Montage der Klammern mit Hilfe der gleichen Werkzeuge wie die, welche die Montage der anderen Bauteile (15, 16) der Leiterplatten ermöglichen, durchgeführt wird.

**Claims**

1. An assembly comprising at least two printed circuit boards which are interconnected by a mechano-electrical connection including clips which engage over adjacent edges of the printed circuit boards, characterized in that the central portion (12) of each clip (13) is disposed at least partially in recesses (26, 27) formed in the printed circuit boards (1, 2) in the vicinity of adjacent edges thereof.

2. Assembly according to claim 1, characterized in that the recesses (26, 27) are elongated perpendicular to the adjacent edges.

3. Assembly according to claim 1 or claim 2, characterized in that the ends of each clip are introduced into holes (8, 9) formed in each printed circuit board on one and the other side of the respective recesses.

4. Assembly according to claim 3, characterized in that the holes (8, 9) which border certain recesses are provided on the conductive side of each printed circuit board at the end of a connecting track.

5. Assembly according to any of the preceding claims, characterized in that each clip is in the form of a simple U including a base (12) and upright legs (10, 11).

6. Assembly according to any of the preceding claims, characterized in that each clip is formed of a rigid conductor wire.

7. Assembly according to any of the preceding claims, characterized in that each clip is formed of a bare conductor wire.

8. Assembly according to any of the preceding claims, characterized in that certain of the clips serve as mechanical connecting member without the function of an electrical connector.

9. Assembly according to any of the preceding claims, characterized in that the clips have such shapes and dimensions that they permit automatic mounting by tools or machines employed for mounting components on a printed circuit board.

10. Assembly according to any of the preceding claims, characterized in that each recess accommodates only a single clip.

11. Assembly according to any of the preceding claims, characterized in that the printed circuit boards are disposed in different planes.

12. A method of manufacturing an assembly of printed circuit boards according to any of the preceding claims, characterized in that one proceeds from a single printed circuit board (3) which is provided with elongate slots (6) defining a line (7) of least mechanical resistance on either side of which the holes (8, 9) for accommodating the clips (13) are formed, that the electrical circuits for each printed circuit board (1, 2; 33, 34, 35) are formed on said board, that the clips (13) are mounted in the holes (8, 9) and the two printed circuit boards are separated by bending about the line (7) of least mechanical resistance, whereby the recesses (26, 27) are obtained by opening of the elongate slots due to the breaking of the single board.

13. Method according to claim 12 for the manufacture of an assembly according to claim 2, characterized in that the elongate slots (6) are so designed that the line of least mechanical resistance is the mean perpendicular of the major axes of these holes.

14. Method according to claim 12 or claim 13, characterized in that the clips are mounted by means of the same tools which permit mounting of the other components (15, 16) of the printed circuit boards.

0 033 677

# FIG_1

# FIG_2

1

# FIG_3

# FIG_4

## FIG_5

31   32

34   33   35

## FIG_6

34

33

35